# EUROPÄISCHE PATENTSCHRIFT

(11) **EP 1 014 768 B1**
(45) Veröffentlichungstag und Bekanntmachung des Hinweises auf die Patenterteilung: **11.05.2005**
(21) Anmeldenummer: 99124262.9
(22) Anmeldetag: 04.12.1999
(51) Int. Cl.: H05K 3/46, H05K 3/02

(54) **Verfahren und Vorrichtung zur Herstellung von Multilayern**
Process and apparatus for fabricating multilayers
Procédé et dispositif pour la fabrication de multicouches

(30) Priorität: 23.12.1998 DE 19859613
(43) Veröffentlichungstag der Anmeldung: 28.06.2000
(73) Patentinhaber: Robert Bürkle GmbH, 72250 Freudenstadt (DE)
(72) Erfinder: Bohn, Hans, 72296 Schopfloch (DE)
(74) Vertreter: Brommer, Hans Joachim, Dr.-Ing.

(56) Entgegenhaltungen:
- WO-A-96/10486
- WO-A-97/25841
- US-A- 3 932 250
- US-A- 5 153 050

## Beschreibung

Die Erfindung betrifft ein Verfahren und eine Vorrichtung zur Herstellung von Multilayern, die an ihren beiden Außenseiten jeweils eine äußere elektrische leitfähige Folie, insbesondere Metallfolie und dazwischen zumindest eine Innenlage mit Leiterbahnen aufweisen, wobei diese Folien und die Innenlage(n) durch Zwischenlagen aus einem klebfähigen Dielektrikum und durch Druck- und Temperatureinwirkung miteinander verbunden werden, indem mehrere Multilayer unter Zwischenschaltung einer Trennlage übereinander gestapelt und sodann gleichzeitig verpreßt werden, wobei mit der Trennlage auch die obere Metallfolie des darunterliegenden Multilayers und die untere Metallfolie des darüberliegenden Multilayers dem Folienstapel zugeführt werden und das vorherige Anbringen der Metallfolien beidseits der Trennlage gegebenenfalls in einem Reinraum erfolgt.

Derartige Multilayer werden zur Herstellung von elektrischen Mehrlagenschaltungen benötigt. Dabei können sich zwischen den beiden äußeren Metallfolien eine Vielzahl unterschiedlicher Innenlagen befinden, wobei diese gegebenenfalls auch elektronische Bauteile aufweisen können.

Die beiden äußeren Lagen bestehen in der Regel aus dünnen Kupferfolien. Dazwischen liegen je nach Aufbau eine oder mehrere elektrisch leitfähige Innenlagen, die unter sich und mit den beiden äußeren Metallfolien durch sogenannte Prepregs verbunden werden. Diese Prepregs sind mit Klebstoff imprägnierte Zwischenlagen, vorzugsweise harzimprägnierte Glasgewebe, bei denen das als Klebstoff fungierende Harz soweit teilpolymerisiert ist, daß die Prepregs bei Raumtemperatur noch nicht klebrig sind, jedoch das als Klebstoff und Dielektrikum fungierende Harz bei erhöhter Temperatur zu schmelzen beginnt und unter Temperatur- und Druckeinwirkung vollständig aushärtet. Die einzelnen Lagen des Multilayers sind dann unlösbar miteinander verbunden und die elektrisch leitfähigen Lagen voneinander isoliert.

Damit die Multilayer rationell hergestellt werden können, ist es üblich, mehrere Multilayer übereinander zu stapeln und sie dann gleichzeitig zu verpressen.

Bei diesem gemeinsamen Verpressen würden aber die äußeren Metallfolien benachbarter Mulitlayer jeweils aneinanderliegen, was zur Folge hätte, daß die Metallfolien sich dem Harzfluß des darunter schmelzenden Prepregs anpassen würden und somit nicht mehr glatt und eben wären. Erforderlich ist aber eine möglichst ebene äußere Metallschicht, weil daraus durch Abätzen der nicht benötigten Metallfläche die Leiterbahnen der äußeren Schaltung erzeugt werden. Diese Leiterbahnen könnten bei einer unebenen äußeren Metallschicht nicht in der erforderlichen Genauigkeit hergestellt werden.

Es ist deshalb bekannt, die äußeren Metallfolien dadurch glatt zu halten, daß zwischen die übereinandergestapelten Multilayer jeweils eine Trennlage, im allgemeinen ein Trennblech gelegt wird. Dieses Trennblech hat eine sehr feine Oberflächenstruktur, damit die dagegen gepreßten Metallfolien nicht verformt, sondern plan und glatt gehalten werden.

Falls vor dem Verpressen der Folie Fremdkörper, insbesondere Schmutpartikel zwischen Trennblech und Metallfolie geraten, würde dies zum Ausschuß des Multilayers führen, denn die Partikel können die Metallfolie durchstoßen und damit einen Unterbruch in einer der später herausgearbeiteten Leiterbahnen verursachen und somit eine nachträgliche Reparatur erfordern oder zum Ausschuß führen.

Ähnlich nachteilig ist es, wenn solche Partikel aus Harz bestehen, weil sich das Harz beim Schmelzen über eine große Fläche verteilt und auf dem Trennblech haftet. In der Metallfolie würde dann nicht nur die bereits geschilderte Unebenheit entstehen, sondern das Trennblech müßte anschließend aufwendig gereinigt werden.

Eine große Gefahr für Verunreinigungen bilden die Prepregs selbst, denn sie müssen zunächst auf Maß geschnitten und dann mit den anderen Lagen übereinander gestapelt werden. In diesem Zustand können Splitter aus dem Glasgewebe oder lose anhaftende Harzteile frei werden und auf die Metallfolie oder das Trennblech fallen. Man muß daher am Legeplatz penibel darauf achten, daß diejenigen Seiten der Metallfolien und der Trennbleche, die beim Preßvorgang gegeneinander zu liegen kommen, absolut frei von Verunreinigungen sind.

Es ist daher auch bekannt, die Innenlagen und Prepregs getrennt von dem Trennblech und der Metallfolie zu behandeln, insbesondere derart, daß die Metallfolien und Trennbleche in einem Reinraum, die Innenlagen und Prepregs hingegen in einem normalen Raum positioniert und zusammengelegt werden. Die Metallfolien werden dabei unten und oben an das Trennblech geklebt. Die Einzelteile des Multilayers pendeln dann zwischen Normalraum und Reinraum hin und her, weil sie an unterschiedlichen Stellen gelegt werden. Dadurch wird allerdings die Produktion etwas komplizierter und der Transport zwischen Normalraum und Reinraum erzeugt ein zusätzliches Verschmutzungsrisiko.

Ein Verfahren gemäß dem Oberbegriff von Anspruch 1 wird in US-A-3 932 250 offenbart.

Hiervon ausgehend liegt der vorliegenden Erfindung die Aufgabe zugrunde, die Herstellung von Multilayern dahingehend zu verbessern, daß das Risiko von Verunreinigungen zwischen der Trennlage - vorstehend als Trennblech bezeichnet - und der Metallfolie weitgehend beseitigt wird. Außerdem soll sich die Erfindung durch einfache Verfahrensschritte auszeichnen.

Diese Aufgabe wird erfindungsgemäß dadurch gelöst, daß die Metallfolie U-förmig um die Trennlage an deren Unterseite, Stirnseite und Oberseite herumgelegt wird, bevor die Trennlage mit der beidseitigen Metallfolie dem unfertigen Multilayerstapel zugeführt wird.

Die Metallfolie ummantelt also praktisch die Trennlage und schirmt sie wie auch den Zwischenraum zwischen ihr und der Trennlage gegenüber der Umgebung ab. Ein Eindringen von Verunreinigungen, insbesondere beim Transport der Trennlage und ihrer Metallfolie wird dadurch drastisch reduziert.

Besonders günstig ist es, wenn die Metallfolie um die in Fahrtrichtung zum Multilayeraufbau vorn liegende Stirnseite der Trennlage herumgelegt wird, weil an der Vorderseite die Verschmutzungsgefahr größer ist als hinten.

Eine Vorrichtung zur Durchführung des erfindungsgemäßen Verfahrens wird in Anspruch 10 definiert.

In der Praxis läßt sich die angestrebte Ummantelung der Trennlage dadurch herbeiführen, daß mit einer Metallfolie gearbeitet wird, die etwa doppelt so lang ist wie eine Trennlage, daß die Trennlage dann auf die in Fahrtrichtung zum Multilayeraufbau hintere Hälfte der Metallfolie aufgelegt und die unbelegte vordere Hälfte der Metallfolie schließlich um 180° auf die Oberseite der Trennlage geklappt wird. Zu diesem Zweck wird ein etwa mittig unterteiltes Transportband verwendet, auf das die Metallfolie aufgelegt wird, daß sodann die Trennlage darübergelegt und anschließend eine im Unterteilungsbereich des Transportbandes angeordnete Legerolle von unten an der Metallfolie angreift, nach oben verschwenkt wird und schließlich die Metallfolie oben auf die Trennlage angewalzt wird. Durch zusätzliche Nachpreßwalzen wird eine plane Anlage der Metallfolie an der Trennlage sichergestellt und eingeschlossene Luft herausgewalzt.

Durch die erfindungsgemäße Ummantelung bietet sich desweiteren der Vorteil, daß die Trennlage in einem Reinraum mit ihrer Metallfolie belegt werden kann und daß sie erst nach ihrer Ummantelung in den Normalraum befördert und auf die dort bereits übereinandergestapelten Lagen des obersten Multilayers aufgelegt wird. Die Innenlagen und Prepregs können also stets im Normalraum bleiben und zu keiner Verschmutzung des Reinraumes führen.

Damit der Transport der Trennlage mit ihrer Metallfolie vom Reinraum in den Normalraum zusätzlich vor Verunreinigungen abgesichert wird, empfiehlt es sich, den Zwischenraum zwischen Trennlage und Metallfolie auch an den beiden gegenüberliegenden, in Transportrichtung verlaufenden Seiten abzudichten. Dies kann vorzugsweise durch Greifer erfolgen, die zugleich den Transport durchführen. Auf diese Weise wird die Metallfolie stets ohne Klebstoff an der Trennlage gehalten.

Nach dem Preß- und Aushärtevorgang sind die übereinandergestapelten Multilayer noch durch die Metallfolien miteinander verbunden. Die Vereinzelung der Multilayer ist jederzeit durch einfaches Abschneiden der Metallfolie im Übergangsbereich möglich, wozu zweckmäßig die Multilayer aufgeklappt und die Trennbleche entnommen werden.

Weitere Merkmale und Vorteile der Erfindung ergeben sich aus der nachfolgenden Beschreibung von Ausführungsbeispielen anhand der Zeichnung; dabei zeigt
- Figur 1: den Aufbau eines Multilayers;
- Figur 2: den Aufbau eines aus mehreren Multilayern bestehenden Preßpaketes;
- Figur 3: das Herstellungsverfahren.

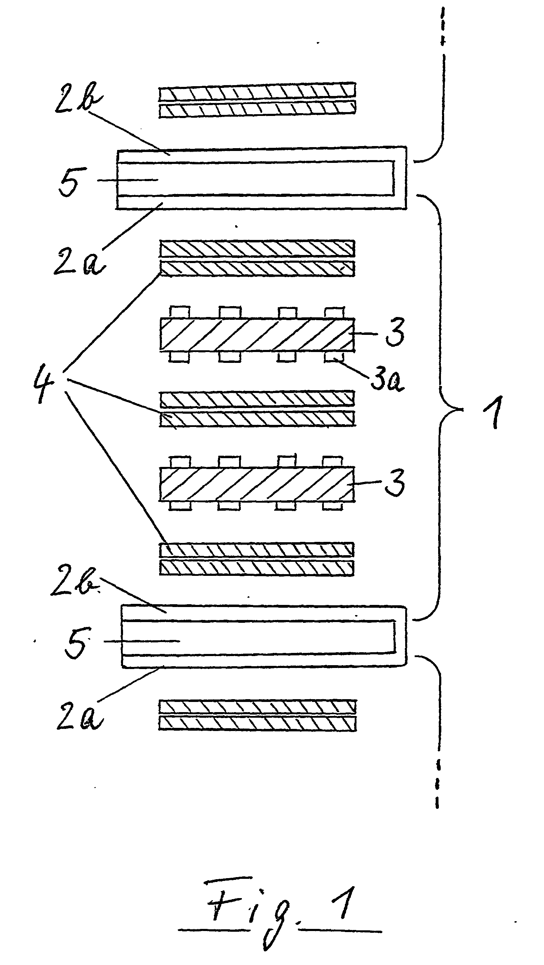

In Figur 1 erkennt man einen Multilayer 1, bei dem die einzelnen Lagen voneinander distanziert dargestellt sind. Er besteht aus einer oberen Außenlage 2a und einer unteren Außenlage 2b, die aus Metall-, insbesondere Kupferfolien bestehen, aus zwei Innenlagen 3, die mit Leiterbahnen 3a bestückt sind, und aus drei mit Klebstoff imprägnierten Zwischenlagen 4, den sogenannten Prepregs, die jeweils zwischen den genannten Lagen angeordnet sind.

Grundsätzlich kann der Schichtaufbau des Multilayers 1 beliebig sein. Wesentlich ist nur, daß er an seinen beiden Außenseiten elektrisch leitende Folien 2a und 2b aufweist.

Im Ausführungsbeispiel handelt es sich um einen 6 Lagen-Multilayer, da er 6 Leitungsebenen enthält.

Unterhalb und oberhalb des beschriebenen Multilayers 1 erkennt man die Enden der benachbarten Multilayer und dadurch wird auch bereits der erfindungsgemäße Verlauf der Metallfolien 2a und 2b deutlich.

Wie eingangs dargestellt, sind benachbarte Multilayer jeweils durch eine Trennlage 5, insbesondere ein Trennblech, voneinander getrennt, damit die angrenzenden Metallfolien beim Preßvorgang nicht verzogen und uneben werden. Wesentlich ist nun, daß die Metallfolien 2a und 2b nicht wie bisher üblich getrennt an der Ober- und Unterseite des Trennbleches angeordnet sind, sondern daß eine einzige Metallfolie 2a, 2b von oben nach unten einstückig durchläuft und die Trennlage 5 somit U-förmig umgibt. So bildet beispielsweise der obere Bereich 2b der Metallfolie den unteren Abschluß des Multilayers 1, während der untere Bereich 2a der Metallfolie den oberen Abschluß eines nur teilweise dargestellten darunter befindlichen Multilayers bildet.

In Figur 1 sind die einzelnen Lagen aus Übersichtlichkeitsgründen in ihrer Dicke stark übertrieben dargestellt. Tatsächlich sind diese Lagen meist nur einige Hundertstel Millimeter bis einige Zehntel Millimeter dick.

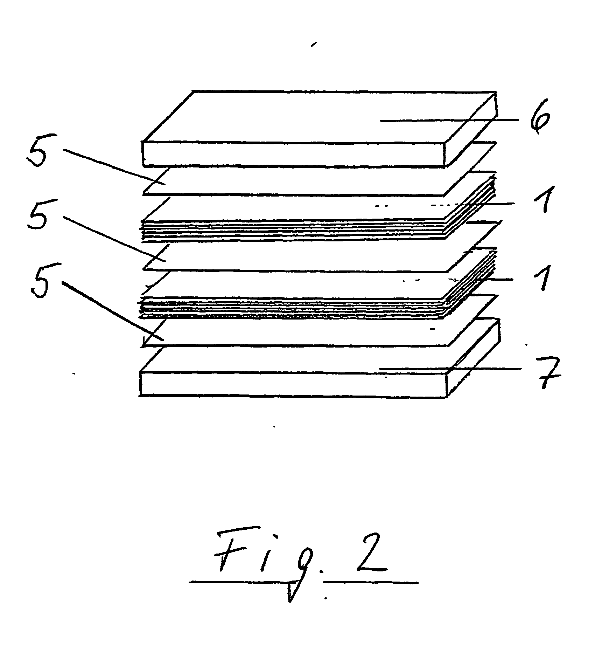

Figur 2 zeigt den Aufbau eines auseinandergezogen dargestellten Preßpaketes, das aus zwei (in Wirklichkeit mehr) Multilayern 1 besteht, wobei die metallischen Außenlagen 2a, 2b jeweils an den Trennlagen 5 angeordnet sind, die sich zwischen den Multilayern wie auch oben und unten befinden. Dieses Preßpaket ist zwischen einer oberen und unteren Preßlehre 6 bzw. 7 angeordnet, die auch als Werkzeug bezeichnet wird. Dabei kann die untere Preßlehre 7 als Träger beim Transport eingesetzt werden.

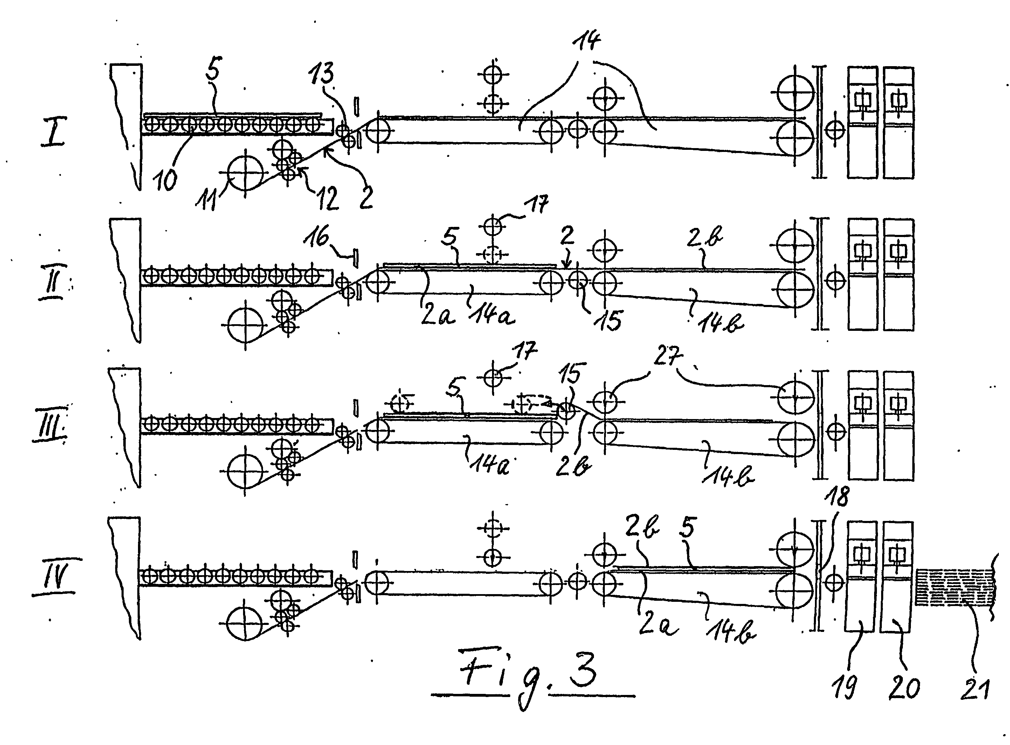

Die Herstellung der mit Metallfolie ummantelten Trennlagen ergibt sich aus Figur 3, wo aufeinanderfolgende Verfahrensschritte I bis IV dargestellt sind.

Im obersten Bild, dem Verfahrensschritt I erkennt man eine Trennlage 5, die auf einer Rollenbahn 10 mit einer nicht näher gezeigten Ausrichtvorrichtung liegt. Darunter ist auf einer Rolle 11 Metallfolie 2 aufgewickelt. Diese Metallfolie läuft über eine Reinigungsvorrichtung mit Ableitung statischer Aufladung und gegebenenfalls eine Glättungsvorrichtung 12 zu einem Paar Förderrollen 13. Diese Förderrollen ziehen die Folie 2 von der Rolle 11 ab und führen sie einem Bandtransport 14 zu. Die Förderrollen 13 können auch durch eine Greifzieheinrichtung ersetzt werden.

Der Bandtransport 14 besteht aus zwei in Förderrichtung aufeinanderfolgenden, jedoch voneinander distanzierten Förderbändern, von denen jedes etwa so lang ist wie die Trennlage 5.

Die Folie 2 wird nun soweit vorgezogen, daß sie sich von vorne nach hinten über den gesamten Bandtransport 14 erstreckt. Dieser Zustand ist in dem oberen Bild I dargestellt. Sodann wird gemäß Bild II die Trennlage 5 mit Hilfe der Rollenbahn 10 und/oder mit von oben angreifenden Saugern nach rechts über die ausgezogene Folie 2 befördert, jedoch nur soweit, daß sie oberhalb der linken Hälfte 14a des Bandtransportes zu liegen kommt, während die vordere Hälfte der Folie unbelegt bleibt. Dieser Zustand ist in Bild II dargestellt.

Anschließend wird eine im Zwischenraum zwischen den beiden Förderbändern 14a und 14b angeordnete Legerolle 15 aktiviert. Diese Legerolle 15 fährt gegen die Unterseite der Folie 2, hebt diese hoch, bis die Rolle entlang der Oberseite der Trennlage 5 nach hinten rollen kann. Sie zieht dabei den unbelegten Teil 2b der Folie nach hinten und legt ihn nach und nach auf die Oberseite der Trennlage 5 ab. Man sieht dies deutlich in Bild III, wo die Legerolle 15 in drei verschiedenen Positionen dargestellt ist.

Damit die Legerolle 15 beim Hochfahren die Trennlage 5 nicht anhebt, fährt eine Niederhalterolle 17 nach unten und hält die Trennlage 5 in ihrer Position, vergleich Bild II, wo die Niederhalterolle 17 in der unteren Position gestrichelt dargestellt ist. Sie fährt erst dann wieder nach oben, wenn die Legerolle 15 den Abrollvorgang an der Oberseite der Trennlage 5 beginnt.

Etwa gleichzeitig wird die Folie durch eine Schneidvorrichtung 16 von der Rolle 11 getrennt. Die Folie kann aber auch auf Länge abgezogen, abgeschnitten und dann positioniert werden.

Durch die Legerolle 15 oder aber durch zusätzliche Andrückrollen wird sichergestellt, daß die umgeklappte obere Lage 2b der Folie plan auf der Trennlage 5 liegen bleibt und Luft zwischen Trennlage und Metallfolie herausgedrückt wurde.

Danach wird die Trennlage 5 mit samt ihrer Metallfolie durch den Bandtransport 15 und Nachpreßwalzen 27 nach rechts durch eine Wandöffnung 18 aus dem Reinraum hinaustransportiert. Das Zwischenstadium ist in dem unteren Bild IV abgebildet.

Der weitere Transport in dem sich rechts anschließenden Normalraum erfolgt durch zwei Greiferpaare 19 und 20. Diese Greiferpaare sind auf nicht dargestellten Führungen gelagert und transportieren die Trennlage mit ihrer Metallfolie zu dem schematisch angedeuteten Legeplatz 21, wo sie schließlich auf den dort vorgelegten Multilayeraufbau abgelegt wird.

Der beschriebene Transport im Normalraum erfolgt zweckmäßig in der Weise, daß der vordere Teil des Metallfolie-Trennlage-Metallfolie-Sandwichs 5, 2a, 2b von dem hinteren Greiferpaar 20 erfaßt und über den Legeplatz getragen wird, wogegen das vordere Greiferpaar 19 dann zum Einsatz kommt, wenn der hintere Teil des Sandwichs aus dem Reinraum austritt. Danach fahren beide Greiferpaare simultan vor, um das Sandwich positionsgenau auf den Legeplatz 21 abzulegen.

Die Greifer 19 und 20 sind zweckmäßig so gestaltet, daß sie beim Fassen des Sandwiches gleichzeitig seine den Greiferpaaren zugewandten Außenseiten abdichten, so daß beim Transport kein Schmutz zwischen Trennlage und Metallfolie eindringen kann.

Der anschließende Preß- und Aushärtevorgang der übereinander gestapelten Multilayer vollzieht sich in der bekannten Weise, weshalb hierauf nicht weiter eingegangen wird.

Zusammenfassend zeichnet sich die Erfindung also durch eine einfache, aber zuverlässige Abschirmung der Trennlage und der an ihm anliegenden Seiten der Metallfolie gegenüber Verunreinigungen aus.

## Patentansprüche

1. Verfahren zur Herstellung von Multilayern (1), die an ihren beiden Außenseiten jeweils eine äußere Metallfolie (2a, 2b) und dazwischen zumindest eine Innenlage (3) aufweisen, wobei diese Folien (2a, 2b), und die Innenlage(n) (3) durch mit Klebstoff imprägnierte Zwischenlagen (4) und durch Druck- und Temperatureinwirkung miteinander verbunden werden, indem die Folien mehrerer Multilayer (1) unter Zwischenschaltung einer Trennlage (5) zwischen benachbarten Multilayern übereinander gestapelt und sodann gleichzeitig verpreßt werden, wobei mit der Trennlage (5) auch die obere Metallfolie (2b) des darunterliegenden Multilayers und die untere Metallfolie des darüberliegenden Multilayers dem unfertigen Multilayeraufbau zugeführt werden und das vorherige Anbringen der Metallfolien (2a, 2b) beidseits der Trennlage (5) gegebenenfalls in einem Reinraum erfolgt,
**dadurch gekennzeichnet,**
**daß** die Metallfolie (2a, 2b) U-förmig um die Trennlage (5) an deren Unterseite, Stirnseite und Oberseite herumgelegt wird, bevor die Trennlage (5) dem Multilayeraufbau (3, 4) zugeführt wird.

2. Verfahren nach Anspruch 1,
**dadurch gekennzeichnet,**
**daß** die Metallfolie (2a, 2b) um die in Fahrtrichtung zum Folienstapel vorn liegende Stirnseite der Trennlage (5) herumgelegt wird.

3. Verfahren nach Anspruch 1,
**dadurch gekennzeichnet,**
**daß** mit einer Metallfolie (2a, 2b) gearbeitet wird, die etwa doppelt so lang ist wie eine Trennlage (5), daß die Trennlage (5) auf die in Fahrtrichtung zum Folienstapel hintere Hälfte (2a) der Metallfolie aufgelegt wird und daß die vordere Hälfte (2b) der Metallfolie auf die Oberseite der Trennlage (5) geklappt wird.

4. Verfahren nach Anspruch 1,
**dadurch gekennzeichnet,**
**daß** die Metallfolie (2a, 2b) auf einen in Transportrichtung unterteilten Bandtransport (14) aufgelegt wird, daß sodann die Trennlage (5) darübergelegt wird und anschließend eine im Unterteilungsbereich des Bandtransportes (14) angeordnete Legerolle (15) von unten an der Metallfolie angreift, an der Stirnseite der Trennlage (5) vorbei hoch und sodann oberhalb der Trennlage (5) weiterfährt und die überstehende Metallfolie (2b) über die Trennlage (5) legt.

5. Verfahren nach Anspruch 1,
**dadurch gekennzeichnet,**
**daß** der obere Bereich (2b) der Metallfolie durch Nachpreßwalzen (27) an die Trennlage (5) gewalzt wird.

6. Verfahren nach Anspruch 1,
**dadurch gekennzeichnet,**
**daß** die Trennlage (5) in einem Reinraum mit ihrer Metallfolie (2a, 2b) belegt wird, sodann in einen Normalraum zu einer Legestation (21) befördert und auf die dort bereits übereinandergestapelten Lagen (3, 4) des obersten Multilayers aufgelegt wird.

7. Verfahren nach Anspruch 1,
**dadurch gekennzeichnet,**
**daß** die Trennlage (5) mit ihrer Metallfolie (2a, 2b) während des Transportes zu einer Legestation (21) seitlich zumindest lokal abgedichtet wird.

8. Verfahren nach Anspruch 7,
**dadurch gekennzeichnet,**
**daß** die Abdichtung durch seitlich angreifende Greifer (19, 20) erfolgt und diese Greifer zugleich den Transport der Trennlage (5) mit ihrer Metallfolie (2a, 2b) durchführen.

9. Verfahren nach Anspruch 1,
**dadurch gekennzeichnet,**
**daß** die übereinandergestapelten Multilayer (1) nach dem Preßvorgang durch Trennen der sie verbindenden Metallfolie (2a, 2b) vereinzelt werden.

10. Vorrichtung zur Durchführung des Verfahrens nach einem der vorhergehenden Ansprüche, mit einer Rollenbahn (10) für die Trennlage (5)
**dadurch gekennzeichnet,**
**daß** zwei in Transportrichtung unter Bildung eines Zwischenraumes aufeinander folgende Transportbänder (14a, 14b) vorgesehen sind und daß in dem Zwischenraum zwischen beiden Transportbändern eine Legerolle (15) angeordnet ist, die nach oben und sodann oberhalb entlang eines der beiden Transportbänder (14a oder 14b) verfahrbar ist.

11. Vorrichtung nach Anspruch 10,
**dadurch gekennzeichnet,**
**daß** jedes der Transportbänder (14a, 14b) etwa so lang wie die Trennlage (5) ist.

12. Vorrichtung nach Anspruch 10,
**dadurch gekennzeichnet,**
**daß** die beiden Transportbänder (14a, 14b) zumindest zeitweise miteinander synchronisierbar sind.

13. Vorrichtung nach Anspruch 10,
**dadurch gekennzeichnet,**
**daß** die mit der Trennlage (5) und/oder mit der Metallfolie (2a, 2b) in Kontakt kommenden Förderelemente, insbesondere die Rollenbahn (10), die Transportbänder (14a, 14b) und die Legerolle (15) mit Säuberungswalzen zur Entfernung von Verunreinigungen zusammenwirken.

## Claims

1. Process for the production of multilayers (1) having an outer metal foil (2a, 2b) on each of their two outer sides and, therebetween, at least one inner layer (3), the foils (2a, 2b) and the inner layer(s) (3) being joined to one another by adhesive-impregnated intermediate layers (4) and by the action of pressure and temperature, wherein the foils of a plurality of multilayers (1) are stacked one above the other, with a separating layer (5) being inserted between adjacent multilayers, and are then compressed simultaneously, the upper metal foil (2b) of the multilayer underneath and the lower metal foil of the multilayer above also being supplied to the unfinished multilayer structure together with the separating layer (5) and the prior application of the metal foils (2a, 2b) on both sides of the separating layer (5) optionally being effected in a clean room,
**characterised in that**
the metal foil (2a, 2b) is laid in a U-shape around the underside, end face and upper side of the separating layer (5) before the separating layer (5) is supplied to the multilayer structure (3, 4).

2. Process according to claim 1,
**characterised in that**
the metal foil (2a, 2b) is laid around the end face of the separating layer (5) located to the front in the direction of travel towards the stack of foils.

3. Process according to claim 1,
**characterised in that**
the metal foil (2a, 2b) used is approximately twice as long as a separating layer (5); the separating layer (5) is applied to the half (2a) of the metal foil that is to the rear in the direction of travel towards the stack of foils; and the forward half (2b) of the metal foil is folded over onto the upper side of the separating layer (5).

4. Process according to claim 1,
**characterised in that**
the metal foil (2a, 2b) is placed onto a belt transporter (14) that is divided in the transport direction; the separating layer (5) is then laid over the top and subsequently a laying roller (15) arranged in the region of the division in the belt transporter (14) engages the metal foil from below, travels upwards past the end face of the separating layer (5) and then continues above the separating layer (5) and lays the overhanging metal foil (2b) over the separating layer (5).

5. Process according to claim 1,
**characterised in that**
the upper region (2b) of the metal foil is rolled onto the separating layer (5) by means of pressing rollers (27).

6. Process according to claim 1,
**characterised in that**
the separating layer (5) is covered with its metal foil (2a, 2b) in a clean room, then conveyed to a laying station (21) in a standard room and placed onto the layers (3, 4) of the uppermost multilayer which have already been stacked there one on top of the other.

7. Process according to claim 1,
**characterised in that**
the separating layer (5) with its metal foil (2a, 2b) is at least locally sealed at the sides during transport to a laying station (21).

8. Process according to claim 7,
**characterised in that**
the sealing is effected by laterally engaging grippers (19, 20), and those grippers at the same time effect the transport of the separating layer (5) with its metal foil (2a, 2b).

9. Process according to claim 1,
**characterised in that**
the multilayers (1) stacked one on top of the other are separated from one another after the pressing operation by separation of the metal foil (2a, 2b) joining them.

10. Apparatus for carrying out the process according to any one of the preceding claims, having a roller conveyor (10) for the separating layer (5),
**characterised in that**
two transport belts (14a, 14b) are provided which follow one after the other in the transport direction with a gap between them; and in the gap between the two transport belts there is arranged a laying roller (15) which can be moved upwards and then along above one of the two transport belts (14a or 14b).

11. Apparatus according to claim 10,
**characterised in that**
each of the transport belts (14a, 14b) is approximately the same length as the separating layer (5).

12. Apparatus according to claim 10,
**characterised in that**
the two transport belts (14a, 14b) are at least intermittently synchronisable with one another.

13. Apparatus according to claim 10,
**characterised in that**
the conveyor elements coming into contact with the separating layer (5) and/or with the metal foil (2a, 2b), especially the roller conveyor (10), the transport belts (14a, 14b) and the laying roller (15), cooperate with cleaning rollers for removing impurities.

## Revendications

1. Procédé pour fabriquer des multicouches (1) dont les deux faces extérieures présentent chacune une feuille de métal extérieure (2a, 2b) et, entre les deux, au moins une couche intérieure (3), sachant que ces feuilles (2a, 2b) et la (les) couche(s) intérieure(s) (3) sont assemblées entre elles par des couches intermédiaires (4) imprégnées de colle et par la mise en oeuvre de pression et de chaleur, en empilant les feuilles de plusieurs multicouches (1) tout en intercalant une couche de séparation (5) entre des multicouches voisins, puis en comprimant le tout simultanément, sachant que la structure multicouche inachevée reçoit avec la couche de séparation (5) également la feuille de métal supérieure (2b) du multicouche situé au-dessous et la feuille de métal inférieure du multicouche situé au-dessus, et que la pose antérieure des feuilles de métal (2a, 2b) sur les deux faces de la couche de séparation (5) intervient le cas échéant dans une salle blanche, **caractérisé en ce que** la feuille de métal (2a, 2b) est posée en forme de U autour de la couche de séparation (5) au niveau de sa face inférieure, de sa face frontale et de sa face supérieure, avant que la couche de séparation (5) ne soit amenée à la structure multicouche (3, 4).

2. Procédé selon la revendication 1, **caractérisé en ce que** la feuille de métal (2a, 2b) est placée autour de la face frontale de la couche de séparation (5) qui est située à l'avant par rapport au sens d'avance vers la pile de feuilles.

3. Procédé selon la revendication 1, **caractérisé en ce que** l'on utilise une feuille de métal (2a, 2b) qui est environ deux fois plus longue qu'une couche de séparation (5), que la couche de séparation (5) est posée sur la moitié arrière (2a) de la feuille de métal par rapport au sens d'avance en direction de la pile de feuilles, et **en ce que** la moitié avant (2b) de la feuille de métal est rabattue sur le dessus de la couche de séparation (5).

4. Procédé selon la revendication 1, **caractérisé en ce que** la feuille de métal (2a, 2b) est posée sur une bande transporteuse (14) divisée dans la direction de transport, **en ce qu'**ensuite la couche de séparation (5) est posée par-dessus, avant qu'un rouleau de pose (15) placé dans la zone de division de la bande transporteuse (14) s'applique contre le dessous de la feuille de métal, passe sur la face frontale de la couche de séparation (5) en remontant, puis poursuive son trajet sur le dessus de la couche de séparation (5) et pose la feuille de métal (2b) qui dépasse sur la couche de séparation (5).

5. Procédé selon la revendication 1, **caractérisé en ce que** la zone supérieure (2b) de la feuille de métal est compactée sur la couche de séparation (5) à l'aide de rouleaux de recompression (27).

6. Procédé selon la revendication 1, **caractérisé en ce que** la couche de séparation (5) est garnie de sa feuille de métal (2a, 2b) dans une salle blanche, puis est acheminée dans un local normal vers une station de pose (21) et est déposée sur les couches (3, 4) déjà empilées du multicouche supérieur.

7. Procédé selon la revendication 1, **caractérisé en ce que** la couche de séparation (5) garnie de sa feuille de métal (2a, 2b) est étanchée au moins localement sur le côté pendant le transport vers une station de pose (21).

8. Procédé selon la revendication 7, **caractérisé en ce que** l'étanchéité est réalisée par des dispositifs de préhension (19, 20) intervenant latéralement, et **en ce que** lesdits dispositifs de préhension assurent simultanément le transport de la couche de séparation (5) avec sa feuille de métal (2a, 2b).

9. Procédé selon la revendication 1, **caractérisé en ce que** les multicouches superposés (1) sont individualisés après l'opération de compression par découpage de la feuille de métal (2a, 2b) qui les relie les uns aux autres.

10. Dispositif pour mettre en oeuvre le procédé selon l'une des revendications précédentes, comprenant un tapis à rouleaux (10) pour la couche de séparation (5), **caractérisé en ce que** sont prévues deux bandes transporteuses (14a, 14b) qui se succèdent dans la direction de transport avec un intervalle, et **en ce que** dans l'intervalle entre les deux bandes transporteuses est placé un rouleau de pose (15) qui peut être déplacé vers le haut, puis sur le dessus le long de l'une des bandes transporteuses (14a ou 14b).

11. Dispositif selon la revendication 10, **caractérisé en ce que** chacune des bandes transporteuses (14a, 14b) est approximativement aussi longue que la couche de séparation (5).

12. Dispositif selon la revendication 10, **caractérisé en ce que** les bandes transporteuses (14a, 14b) peuvent être synchronisées entre elles au moins par moments.

13. Dispositif selon la revendication 10, **caractérisé en ce que** les éléments transporteurs entrant en contact avec la couche de séparation (5) et/ou avec la feuille de métal (2a, 2b), notamment le tapis à rouleaux (10), les bandes transporteuses (14a, 14b) et le rouleau de pose (15), coopèrent avec des rouleaux de nettoyage pour éliminer des impuretés.
